# EUROPÄISCHE PATENTSCHRIFT

(11) **EP 1 053 660 B1**
(45) Veröffentlichungstag und Bekanntmachung des Hinweises auf die Patenterteilung: **10.08.2016**
(21) Anmeldenummer: 99963225.0
(22) Anmeldetag: 12.11.1999
(51) Int. Cl.: H01J 37/32, H05H 1/30

(54) **VORRICHTUNG ZUR ERZEUGUNG EINES FREIEN KALTEN NICHT-THERMISCHEN PLASMASTRAHLES**
DEVICE FOR PRODUCING A FREE COLD NON-THERMAL PLASMA BEAM
DISPOSITIF DE PRODUCTION D'UN JET DE PLASMA FROID NON-THERMIQUE LIBRE

(30) Priorität: 07.12.1998 DE 19856307
(43) Veröffentlichungstag der Anmeldung: 22.11.2000
(73) Patentinhaber: ROBERT BOSCH GMBH, 70442 Stuttgart (DE)
(72) Erfinder: GROSSE, Stefan, D-70839 Gerlingen (DE); WEBER, Thomas, D-70825 Korntal-Münchingen (DE); GAHL, Astrid, D-70197 Stuttgart (DE)
(86) Internationale Anmeldenummer: PCT/DE1999/003612
(87) Internationale Veröffentlichungsnummer: WO 2000/035256

(56) Entgegenhaltungen:
- EP-A- 0 296 921
- JP-A- S6 436 021
- JP-A- H02 170 979
- JP-A- S63 234 519
- US-A- 5 002 632
- VULKANOVIC ET AL.: "Plasma etching of organic materials. II. Polymide etching and passivation downstream of an O2-CF4-Ar microwave plasma." JOURNAL OF VACUUM SCIENCE & TECHNOLOGY,SECTION B, WOODBURY, NY,USA, Bd. 6, Nr. 1, Januar 1988 (1988-01), Seiten 66-71, XP002133264 ,
- RICARD A: "INTRODUCTION AUX PLASMAS FROIDS" REE: REVUE GENERALE DE L'ELECTRICITE ET DE L'ELECTRONIQUE,FR,REVUE GENERALE DE L'ELECTRICITE S.A, Nr. 4, 1. April 1998 (1998-04-01), Seiten 82-84, XP000781176 ISSN: 1265-6534
- PATENT ABSTRACTS OF JAPAN vol. 1995, no. 03, 28. April 1995 (1995-04-28) & JP 06 336662 A (KAWASAKI STEEL CORP), 6. Dezember 1994 (1994-12-06)
- MOISAN M.; ZAKRZEWSKI Z.: "Plasma source based on the propagation of electromagnetic surface waves", J.PHYS.D: APPL. PHYS., 1991, pages 1025-1048, XP001154892,
- MARGOT J.; MOISAN M.: "Physics of surface-wave discharges", PROCEEDINGS PLASMA PROCESSING OF SEMICONDUCTORS, 1997, pages 187-210, XP000884425,
- MOISAN M. ET AL: "Radio frequency or microwave reators? Factors determining the optimum frequency of operation", J.VAC.SCI.TECHNOL., 1991,

## Beschreibung

### Stand der Technik

Die Erfindung betrifft eine Vorrichtung zur Erzeugung eines freien kalten Plasmastrahles nach der Gattung des unabhängigen Anspruches 1.

In der Oberflächenbehandlung von Werkstücken ist der Einsatz von Plasmatechnologien gängiger Stand der Technik. Es gibt einerseits thermische Plasmen, die bei Atmosphärendruck oder im atmosphärennahen Druckbereich erzeugt werden und Temperaturen von mehreren tausend Grad erreichen können. Auf der anderen Seite stehen kalte Plasmen, die im Vakuum betrieben werden. Sie stellen hohe Aktivierungsenergien für chemische Reaktionen zur Verfügung, heizen das Gas typischerweise nicht über 500°C auf und ermöglichen auf diese Weise Oberflächenbehandlungen und Schichtdeposition auch auf temperaturempfindlichen Werkstücken. Zudem können manche Schichten mit technisch relevanten Eigenschaften ausschließlich mit kalten Plasmen synthetisiert werden. Insbesondere Plasmen, die durch Einstrahlung von Mikrowellen erzeugt werden, bieten dabei für Beschichtungsprozesse im Vakuum eine hohe Depositionsrate bei guter Schichtqualität. Typische Plasmadichten dieser Verfahren liegen bei ca. 10¹¹ Ionen/cm³.

Bei diesen Technologien tritt jedoch häufig die Schwierigkeit auf, die Erzeugung des Plasmas von dessen Einsatz zur Oberflächenbehandlung oder Schichtabscheidung räumlich zu trennen, da ansonsten die Apparatur zur Erzeugung des Plasmas beispielsweise durch Depositionsprozesse innerhalb der Apparatur in unerwünschter Weise in Mitleidenschaft gezogen wird, was hohe Kosten für Wartung und Standzeiten bedeutet.

Im Stand der Technik ist dazu bereits bekannt, einen freien, jedoch heißen d.h. thermischen Plasmastrahl aus einer Plasmaquelle herauszuführen und somit die Plasmaerzeugung und den technologischen Einsatz dieses Plasmastrahles beispielsweise innerhalb einer nachgeschalteten Beschichtungsapparatur räumlich voneinander zu trennen. Unter einem freien Plasmastrahl wird dabei allgemein ein Plasmastrahl verstanden, der sich in einem größeren Volumen ohne Führung durch apparative Gegebenheiten oder Hilfsmittel ausbreitet. Beispiele hierfür sind verschiedene Varianten des Plasmaspritzens, wie sie in der Veröffentlichung "VI. Workshop für Plasmatechnik (1998), TU Ilmenau, FG Plasma- und Oberflächentechnik" zusammengestellt sind. Diese freien, jedoch heißen oder thermischen Plasmastrahlen weiten sich beim Eintritt in die Beschichtungsapparatur, in der Atmosphärendruck oder atmosphärennaher Druck herrscht, nicht wesentlich auf und können so gezielt zum Einsatzort geführt werden.

Viele technisch relevante Oberflächenbehandlungen und Beschichtungen können, beispielsweise aus verfahrenstechnischen oder chemischen Gründen, ausschließlich im Vakuum mit kalten Plasmen durchgeführt werden. Im Vakuum tritt jedoch die Schwierigkeit auf, einen freien, gebündelten Strahl zu erzeugen, der nicht durch Diffusion oder Konvektion auseinandergetrieben wird.

Im Stand der Technik ist weiter die Ausbreitung von Plasmen innerhalb einer für elektromagnetische Strahlung transparenten Röhre aufgrund von elektromagnetischen Oberflächenwellen bekannt, deren Frequenz im Mikrowellenbereich oder in benachbarten Frequenzbändern liegt. Diese Oberflächenwellen pflanzen sich entlang der Grenzfläche zwischen dem elektrisch leitenden Plasma und der Röhre fort. Plasmaquellen, die auf diesem Prinzip basieren, werden als "wave launcher" bezeichnet (M. Moisan und Z. Zakrewski, Plasma sources based on the propagation of electromagnetic surface waves, J. Phys. D: Appl. Phys. 24 (1991) 1025-1048) und arbeiten sowohl im Vakuum als auch bei Atmosphärendruck. Bei Atmosphärendruck kann dieses Plasma als thermisches Plasma in Form eines freien, gebündelten Strahls außerhalb der Röhre über wenige Zentimeter fortgesetzt werden. Daß diese Möglichkeit für kalte Plasmen und insbesondere für kalte Mikrowellenplasmen oder Hochfrequenzplasmen im Vakuum ebenfalls besteht, wird in der Fachliteratur bisher nicht für möglich gehalten (J. Margot und M. Moisan, Physics of surface wave discharges, Proceedings of Plasma Processing of Semiconductors, Chateau de Bonas, France (1997), 187-210).

Ein Plasma ist typischerweise an dem Ort der Einkopplung am dichtesten, also direkt an oder in der Plasmaquelle. Man daher unterscheidet im Stand der Technik bei Beschichtungsprozessen daher zwischen direkten Prozessen und remote-Prozessen. Bei den direkten Prozessen findet die Abscheidung durch Zugabe von Reaktivgas direkt am Ort der Einkopplung statt, also am Ort der höchsten Plasmadichte, so daß hier die Anregungszustände am effektivsten zur Schichtdeposition genutzt werden können. Ein Nachteil der direkten Prozesse ist jedoch, daß zwangsläufig die Einkoppelstrukturen zur Erzeugung des Plasmas durch unerwünschte Depositionsprozesse im Laufe einer Beschichtung in Mitleidenschaft gezogen werden. Um diesen Nachteil zu vermeiden, sind vielfach remote-Prozesse üblich. Dabei wird das Reaktivgas einem Plasma erst in einiger Entfernung von der Einkoppelstruktur zugegeben, um die Verunreinigung zu reduzieren. Hiermit ist dann allerdings auch die Plasmadichte und somit die Effektivität reduziert.

Die Realisierung eines freien kalten hochfrequenten Plasmastrahles und eine dazu geeignete Vorrichtung, wobei zunächst innerhalb einer Plasmaquelle in einem für elektromagnetische Strahlung transparenten Hohlkörper ein kaltes Plasma erzeugt wird, das danach als gebündelter Plasmastrahl in eine von der Plasmaquelle und der Erzeugung dieses Strahles separate Arbeitskammer geführt wird, in der ein Vakuum herrscht, und sich dort über eine größere Strecke von bis zu 1 m ausbreitet, ist bisher nicht bekannt.

JP 63 234519 (Fig.1,2) offenbart eine Vorrichtung zur Erzeugung eines freien kalten nicht-thermischen Plasmastrahles. Das Plasma wird mittels Hochfrequenzquelle mit Elektroden 21 a, 21 b erzeugt. Der Plasmastrahl wird mittels einer elektrischen Spannung die zwischen dem Werkstückhalter 35 und einem Elektrodenblech 27a, das zwischen dem Hohlkörper 20 und der Arbeitskammer B angeordnet ist, aus dem Plasmaerzeugungsbereich des Hohlkörpers extrahiert.

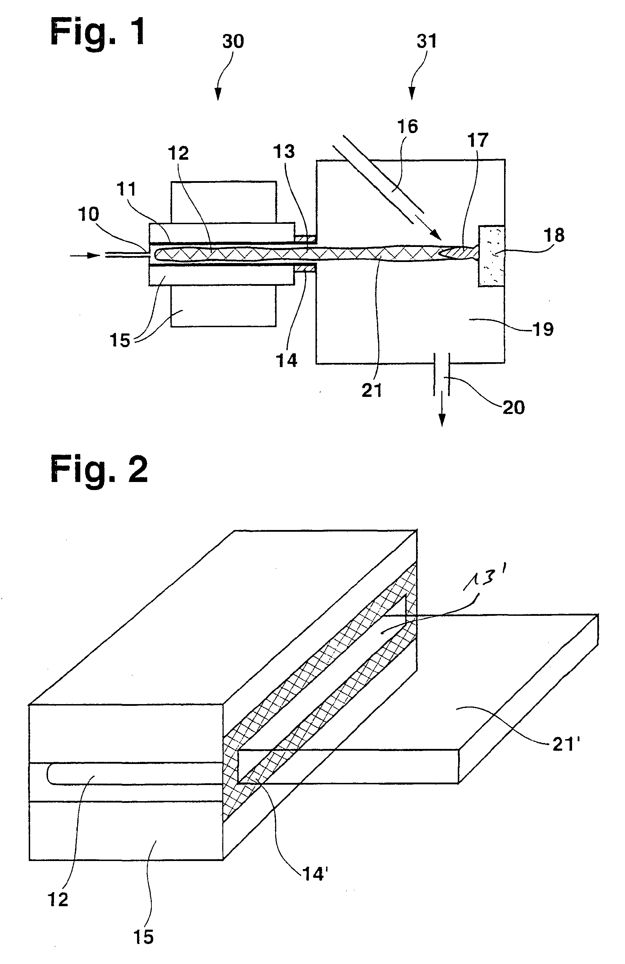

In JP 02170979 wird ein kaltes, nicht-thermisches Plasma mittels einer Mikrowellenplasmaquelle mit Schlitzantenneneinkopplung erzeugt (siehe Fig.1-6). Der Metallzylinder 12 dient hierbei zur Schlitzantenneneinkopplung der Mikrowellen. Das Plasma wird in die Arbeitskammer geleitet. Die in Fig.1-6 dargestellte Plasmaausbreitung kann als sich stark aufweitender Plasmastrahl angesehen werden. JP 01036021 offenbart entsprechendes.

In MOISAN M ET AL.: "Radio frequency or microwave reators? Factors determining the optimum frequency of operation" J.VAC.SCLTECHNOL., (1991) wird ein kaltes, nicht-thermisches Plasma durch Mikrowellenanregung mittels eines 'wave launchers' (Surfatrons) in einer für elektromagnetische Strahlung transparenten Röhre erzeugt und in eine Arbeitskammer ("reactor"; deutlich aufgeweitete Röhre) geleitet (vgl. Fig.21).

In MOISAN, M AND ZAKRZEWSKI, Z: "Plasma source based on the propagation of electromagnetic surface waves" J.PHYS.D: APPL. PHYS., 1991, Seiten 1025-1048, XP001154892 wird ein kaltes, nicht-thermisches Plasma (afterglow plasma) durch Mikrowellenanregung mittels eines 'wave launchers' in einer für elektromagnetische Strahlung transparenten Röhre erzeugt und in eine Arbeitskammer geleitet, vgl. Fig.30d. Gemäß Fig.30d breitet sich das Plasma, unmittelbar nach Eintritt in die Arbeitskammer, diffus großvolumig ausdehnend aus.

In der Schrift VULKANOVIC ET AL.: "Plasma etching of organic materials. II. Polymide etching and passivation downstream of an O2-CF4-Ar microwave plasma." JOURNAL OF VACUUM SCIENCE & TECHNOLOGY, SECTION B, WOODBURY, NY, USA, Bd. 6, Nr. 1, Januar 1988 (1988-01), Seiten 66-71, XP002133264 wird zwar ein Plasma erzeugt, aber es kommen am Substrat nur noch Reaktive und Neutrale an. Elektronen und Ionen wie beim Anmeldungsgegenstand sind nicht vorhanden.

Bei der Entgegenhaltung RICARD A: "INTRODUCTION AUX PLASMAS FROIDS' REE: REVUE GENERALE DE L'ELECTRICITE ET DE L'ELECTRONIQUE, FR, REVUE GENERALE DE L'ELECTRICITE S.A, Nr. 4, 1. April 1998 (1998-04-01), Seiten 82-84, XP000781176 ISSN: 1265-6534 ist kein freier kalter Plasmastrahl vorhanden. Es werden dort Mikrowellenplasmen beschrieben, die mit Antennen innerhalb der Entladungskammer oder mit Resonatoren erzeugt werden können. Diese bieten normalerweise nicht die Möglichkeit, freie Plasmastrahlen zu erzeugen.

### Vorteile der Erfindung

Die erfindungsgemäße Vorrichtung mit den kennzeichnenden Merkmalen des Anspruchs 1 hat gegenüber dem Stand der Technik den Vorteil, daß ein kaltes Gasplasma in Form eines gebündelten, hochfrequenten Plasmastrahles in eine von der Plasmaquelle und der Erzeugung dieses Strahles separate Arbeitskammer, in der Vakuum herrscht, geführt wird und sich dort über eine größere Strecke als freier, kalter Plasmastrahl mit nahezu konstantem Durchmesser d.h. nur geringer Diffusionsaufweitung ausbreitet. Damit werden insbesondere in der industriellen Praxis bisher nicht durchführbare Prozesse wie beispielsweise eine gezielte Behandlung von Werkstücken möglich. Der freie kalte Plasmastrahl ist durch den apparativen Aufbau in der Arbeitskammer und dem Plasmaerzeugungsbereich sowie deren Verbindung bereits ohne weitere, zusätzlich erzeugte elektromagnetische Felder über eine große Strecke in der Arbeitskammer stabil und bleibt gebündelt. Damit ist auch geometrisch freies Arbeiten möglich.

Weiterhin bietet die erfindungsgemäße Vorrichtung die Möglichkeit, die Vorteile von direkten Beschichtungsprozessen und remote-Prozessen miteinander zu verbinden. Durch die Erzeugung eines freien Plasmastrahles ist eine direkte Beschichtung im intensiven Plasmastrahl durch Zugabe eines Reaktivgases bei gleichzeitiger, größerer Entfernung des Beschichtungsprozesses vom Ort der Plasmaerzeugung möglich. Dies vereinfacht die Wartung erheblich, verkürzt die Standzeiten der Anlage und erhöht zugleich die Effektivität des Beschichtungsprozesses.

Der erfindungsgemäße kalte Plasmastrahl weist weiterhin sehr hohe Plasmadichten von mehr als 10¹² Ionen/cm³ auf, was eine hohe Effektivität zur Folge hat. So werden bei Beschichtungsprozessen hohe Wachstumsraten und bei Ätzprozessen hohe Abtragungsraten ermöglicht.

Da der kalte Plasmastrahl das Gas nur wenig aufheizt und gleichzeitig eine hohe Aktivierungsenergie für chemische Reaktionen zur Verfügung stellt, können somit vorteilhaft auch temperaturempfindliche Werkstücke behandelt werden.

Weitere vorteilhafte Weiterbildungen der Erfindung ergeben sich aus den in den Unteransprüchen genannten Maßnahmen.

So ist es sehr vorteilhaft, daß der freie kalte hochfrequente Plasmastrahl in einer Arbeitskammer eingesetzt wird, in der ein Unterdruck und insbesondere ein Vakuum von 0,1 Pa bis 1000 Pa herrscht. Einerseits ist der Betrieb der erfindungsgemäßen Vorrichtung somit auch im Nicht-Hochvakuum möglich, andererseits ist ein Vakuum für viele technisch relevante Plasmaprozesse unerläßlich, damit diese effektiv ablaufen können. Beispiele hierfür sind Ätzprozesse, Prozesse zur Vermittlung von Schichthaftung und das Abscheiden von äußerst kompakten Schichten mit geringer Oberflächenrauhigkeit.

Durchmesser und Länge des freien Plasmastrahles und damit die räumliche Variation von Abscheide-, Wachstums- und Ätzraten lassen sich weiterhin in einfacher Weise über Prozeßparameter wie beispielsweise den Gasdruck, den Gasfluß, die Mikrowellen- oder Hochfrequenzleistung, sowie die Hochfrequenz oder Mikrowellenfrequenz zur Erzeugung des Gasplasmas steuern. Die Erzeugung des Gasplasmas innerhalb des für elektromagnetische Strahlung transparenten Hohlkörpers erfolgt dabei über eine an sich bekannte und kommerziell erhältliche Mikrowellenplasmaquelle mit Schlitzantenneneinkopplung.

Außerdem ist es sehr vorteilhaft, daß die Ausbreitungsrichtung des freien Plasmastrahles in der Arbeitskammer nicht oder nur unwesentlich durch die Richtung des Gasflusses innerhalb der Arbeitskammer beeinflußt wird, da für die Ausbreitungsrichtung vor allem die elektromagnetische Feldverteilung entscheidend ist. So ist es beispielsweise möglich, daß die Strömungsrichtung des Gases in der Arbeitskammer senkrecht zur Ausbreitungsrichtung des freien Plasmastrahles erfolgt, ohne daß dieser merklich gekrümmt wird. Diese Eigenschaft ermöglicht es auch, zwei sich treffende, beispielsweise auf einer Linie gegeneinander gerichtete freie Plasmastrahlen innerhalb der Arbeitskammer zu erzeugen. Der sich damit ergebende Gesamtstrahl ist dann durch eine erhöhte axiale Homogenität gekennzeichnet. Diese Anordnung eignet sich insbesondere zur Beschichtung großflächigerer Werkstücke.

Weiterhin ist es vorteilhaft möglich, die Einkoppelgeometrie, das heißt die Form des für elektromagnetische Strahlung transparenten Hohlkörpers, in dem das Plasma zunächst erzeugt wird, und der Strahlaustrittsöffnung an spezielle Anforderungen einer Strahlgeometrie in der Arbeitskammer anzupassen. So führt die flächige Ausbildung des Hohlkörpers beispielsweise als Quader mit einer Strahlaustrittsöffnung in Form eines Schlitzes dazu, daß der erzeugte freie Plasmastrahl flächig in einer Plasmastrahlebene in die Arbeitskammer eintritt. Der so erzeugte freie Plasmastrahl eignet sich vorteilhaft für eine großflächige Beschichtung, Reinigung oder Ätzung von Werkstücken.

Die Nutzung des freien Plasmastrahls in Kombination mit anderen Verfahren, auch mit Nicht-Plasmastrahlquellen, ist auf einfache Weise möglich.

### Zeichnungen

Die Erfindung wird anhand der Zeichnung und in der nachfolgenden Beschreibung näher erläutert. Figur 1 zeigt eine Prinzipskizze einer Vorrichtung zur Erzeugung eines freien Plasmastrahles im Schnitt, Figur 2 eine perspektivische Ansicht eines quaderförmigen, für elektromagnetische Strahlung transparenten Hohlkörpers mit einer schlitzförmigen Strahlaustrittsöffnung und Figur 3 eine Skizze eines Hohlkörpers mit innenliegender Gaszuführung.

### Ausführungsbeispiele

Die Figur 1 erläutert ein erstes Ausführungsbeispiel der Vorrichtung zur Erzeugung eines freien kalten Plasmastrahles. Dazu wird in einem für elektromagnetische Strahlung transparenten Hohlkörper 11 über eine Gaseintrittsöffnung 10 ein Gas eingeleitet. Dieses Gase ist beispielsweise ein Edelgas, insbesondere Argon, oder Sauerstoff, Stickstoff oder Wasserstoff, das mit einem Gasfluß von 100 sccm bis 10000 sccm, vorzugsweise von 1000 sccm bis 10000 sccm in den Hohlkörper 11 bei einem Druck von 0,1 Pa bis 1000 Pa, vorzugsweise von 50 Pa eingeleitet wird. Den Hohlkörper 11 umgibt eine kommerziell erhältliche, an sich bekannte hochfrequente Plasmaquelle 15, die als Mikrowellenplasmaquelle mit Schlitzantenneneinkopplung ausgeführt ist und bei einer Frequenz von 2,45 GHz arbeitet. Die hochfrequente Plasmaquelle 15 koppelt in den Hohlkörper 11 mit dem darin befindlichen Gasvolumen eine elektromagnetische Leistung von 20 W bis 10 kW, vorzugsweise von 500 W ein und erzeugt dadurch innerhalb des Hohlkörpers 11 ein kaltes Gasplasma 12.

Unter Mikrowellen werden dabei elektromagnetische Wellen mit einer Frequenz von mehr als 300 MHz verstanden, wohingegen eine Hochfrequenzplasmaquelle lediglich mit Frequenzen von ca. 10 MHz bis zu 300 MHz arbeitet.

Das Gasplasma 12 breitet sich in dem Hohlkörper 11, der als Quarzglasröhre mit einer Länge von 300 mm und einem Durchmesser von 25 mm ausgebildet ist, aus und wird zunächst durch dessen Wände zusammengehalten. Der Hohlkörper 11 kann alternativ auch aus einem sonstigen, jedoch für elektromagnetische Strahlung transparenten Material bestehen und beispielsweise als Glas- oder Keramikröhre ausgebildet sein.

An der Grenze zwischen dem Gasplasma 12, das als elektrischer Leiter wirkt, und der umgebenden Röhre als Hohlkörper 11 können sich elektromagnetische Oberflächenwellen ausbreiten.

Innerhalb des angegebenen Leistungs-, Druck- und Gasflußbereichs wird das Gasplasma 12 dann aus dem Hohlkörper 11 in die Arbeitskammer 19 als freier kalter Plasmastrahl 21 hinausgeführt. Dabei breiten sich elektromagnetische Oberflächenwellen auf dem freien kalten Plasmastrahl 21 aus und bündeln ihn gleichzeitig.

Die Arbeitskammer 19 ist insbesondere metallisch mit einer typischen Kantenlänge von 0,40 m, so daß die Ausbildung und Ausbreitung des freien Plasmastrahles 21 nicht behindert wird. Der freie kalte Plasmastrahl 21 weitet sich im Vakuum in der Arbeitskammer 19, abgesehen von einem geringen Aufweiten unmittelbar beim Eintritt in die Arbeitskammer 19, über eine Strecke von typischerweise ca. 0,5 m nicht wesentlich durch Diffusion oder Konvektion auf, sondern bleibt gebündelt. Innerhalb der Arbeitskammer 19 herrscht analog zum Hohlkörper 11 ein Vakuum von 1 Pa bis 1000 Pa, vorzugsweise von ca. 50 Pa, das über an einem Absaugrohr 20 angeschlossene Pumpen aufrechterhalten wird.

Der Durchmesser und die Länge des freien kalten Plasmastrahles 21 läßt sich dabei über die Einstellungen des Gasflusses, des Gasdruckes und der eingekoppelten Mikrowellen- oder Hochfrequenzleistung beeinflussen. Innerhalb der Arbeitskammer 19 trifft der freie Plasmastrahl 21 auf ein Werkstück 18, wobei dem Plasmastrahl 21 vor dem Auftreffen ein Reaktivgas, beispielsweise Acetylen, Methan, Silan oder Dampf von Hexamethyldisiloxan (HMDS(O)), Tetramethylsilan (TMS) oder Tetraethoxysilan (TEOS) über eine Gaszuführung 16 zugeführt wird, so daß sich vor dem Werkstück 18 eine Reaktionszone 17 ausbildet und auf dem Werkstück 18 eine Oberflächenbeschichtung stattfindet. Weiterhin können auch mehrere Reaktivgase in den freien Plasmastrahl 21 eingeleitet werden oder es kann ohne Reaktivgas nur mit dem freien Plasmastrahl 21, beispielsweise zur Reinigung des Werkstückes 18, gearbeitet werden. Innerhalb des freien Plasmastrahles 21 können Plasmadichten von mehr als 10¹² Ionen/cm³ erreicht werden.

Die Bündelung des freien Plasmastrahles 21 kann mit Hilfe von Oberflächenwellen erklärt werden, die sich von dem Hohlkörper 11, innerhalb dessen das kalte Gasplasma 12 erzeugt wird, in die Arbeitskammer hinein fortsetzen. Die elektrische Feldstärke von Oberflächenwellen ist an der Grenzfläche zwischen dem Plasma 21, 12 und dem Hohlkörper 11 und insbesondere auch dem Vakuum, maximal. Es wirken daher ponderomotive Kräfte (F. Chen, Introduction to Plasma Physics and Controlled Fusion, Vol.1, Plenum Press, New York (1984)) auf Elektronen und Ionen des freien kalten Plasmastrahles 21 in Richtung abnehmender Feldstärke, insbesondere also auch in Richtung der Strahlmitte, so daß ein Gegenstrom zum Diffusions- oder Konvektionsstrom, der eine Aufweitung bewirkt, vorhanden ist. So können Oberflächenwellen einerseits den freien Plasmastrahl 21 bündeln und ihn zugleich als Ausbreitungsmedium nutzen.

Die Vorrichtung gliedert sich somit in zwei räumlich separierte Bereich, einen Plasmaerzeugungsbereich 30 und einen Arbeitsbereich 31. Die Verbindung beider Bereiche wird gewährleistet über eine Übergangselement 14, das als metallischer Ring ausgebildet ist und den Hohlkörper 11 bereichsweise umgibt oder sich zwischen dem Hohlkörper 11 und der Arbeitskammer 19 befindet.

Sowohl die Dimensionen der hochfrequenten Plasmaquelle 15, insbesondere die Dimensionen des Hohlkörpers 11 und die des freien Plasmastrahles 21 und des Gasplasmas 12 skalieren mit Parametern wie der Frequenz der elektromagnetischen Strahlung, der Leistung, des Druckes, des Gasflusses und der Gasart. So kann der Hohlkörper 11 in Form einer Röhre eine Länge von 1 cm bis zu 2 m aufweisen und einen Innendurchmesser von 1 mm bis 200 mm besitzen.

Die hochfrequente Plasmaquelle 15 kann sowohl im continuous wave Betrieb als auch im Pulsbetrieb betrieben werden. Der Pulsbetrieb bietet dabei den Vorteil homogenerer Abscheide- und Ätzraten, was insbesondere Vorteile im Fall der Beschichtung dreidimensionaler Werkstücke hat. Zudem findet im Pulsbetrieb Aktivierung der Gase mit hoher Leistung bei verringerter thermischer Belastung statt.

Figur 2 erläutert ein weiteres Ausführungsbeispiel der Erfindung, wobei der für elektromagnetische Strahlung transparente Hohlkörper 11 nicht die Form einer Röhre, sondern eines Quaders hat, der mit einer Strahlaustrittsöffnung 13' in Form eines Schlitzes mit einer Höhe von ca. 25 mm versehen ist. Innerhalb des Quaders wird, analog dem ersten Ausführungsbeispiel, über eine hochfrequente Plasmaquelle 15 mit Schlitzantenneneinkopplung, das kalte Gasplasma 12 erzeugt, wobei dem Quader auf der der Strahlaustrittsöffnung 13' gegenüberliegenden Seite über einen Gaseintrittsschlitz 10' Argon zugeführt wird. Der Hohlkörper 11 ist wiederum beispielsweise mit einem die Strahlaustrittsöffnung 13' umgebenden Metallring 14' als Übergangselement 14 versehen, der den Hohlkörper 11 mit der Arbeitskammer 19 verbindet. Aus dem Hohlkörper 11 tritt somit ein freier kalter Plasmastrahl flächig als Plasmastrahlebene 21' in die Arbeitskammer 19 ein. Die weiteren Parameter dieses Ausführungsbeispiels (Gasart, Gasdruck, Gasfluß, eingekoppelte Leistung, Mikrowellenfrequenz oder Hochfrequenz) werden entsprechend den Parametern des ersten Ausführungsbeispiels skaliert.

Ein weiteres Ausführungsbeispiel der Erfindung sieht vor, daß zwei entgegengesetzt gerichtete, auf einer Linie liegende, jeweils analog dem ersten Ausführungsbeispiel erzeugte freie Plasmastrahlen 21 über zwei gegenüberliegende Plasmaerzeugungsbereiche 30 in den Arbeitsbereich 31 eingeführt werden. Dies führt zu einer axial homogeneren Plasmadichte. Natürlich kann dieses Ausführungsbeispiel auch derart ausgestaltet sein, daß zwei entgegengesetzt gerichtete, in einer Ebene liegende Plasmastrahlebenen 21' in die Arbeitskammer 19 geführt werden.

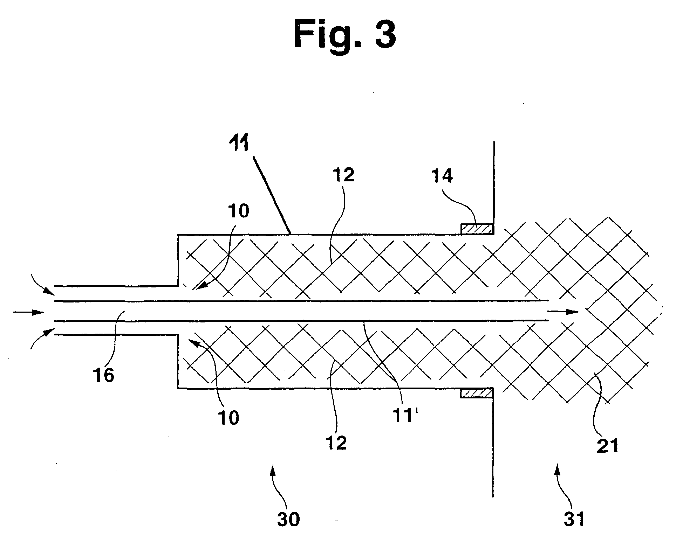

Figur 3 zeigt eine weitere Modifikation der erfindungsgemäßen Vorrichtung, wobei sich innerhalb des Hohlkörpers 11, der erneut als Quarzglasröhre analog dem ersten Ausführungsbeispiel ausgebildet ist, ein weiterer Hohlkörper 11' befindet, der insbesondere die Form einer koaxialen Röhre hat und ebenfalls aus einem für elektromagnetische Strahlung transparenten Material wie Quarzglas besteht. In diesem Ausführungsbeispiel wird das Reaktivgas nicht in der Arbeitskammer 19 in den freien Plasmastrahl 21 geführt, sondern über die Gaszuführung 16 durch den weiteren Hohlkörper 11' koaxial durch den Hohlkörper 11 geleitet. Dabei wird, analog dem ersten Ausführungsbeispiel, in den Hohlkörper 11 über eine Gaseintrittsöffnung 10 ein Gas eingeleitet, das in dem Hohlkörper 11 in der beschriebener Weise zu einem kalten Gasplasma 12 angeregt wird und in Form eines freien Plasmastrahles 21 in die Arbeitskammer geführt wird. Das eingeleitete Gas ist beispielsweise Argon. Das im Inneren des weiteren Hohlkörpers 11' insbesondere koaxial durch den Hohlkörper 11 geführte Reaktivgas ist beispielsweise Acetylen. Das zugeführte Reaktivgas und das kalte Gasplasma 12 vermischen sich somit erst in der Arbeitskammer 19 in dem freien kalten Plasmastrahl 21. Diese Anordnung der Zuführung des Reaktivgases in den freien Plasmastrahl 21 hat strömungstechnische Vorteile und bewirkt eine bessere Vermischung des Reaktivgases. Außerdem ist es damit möglich, eine Anregung des Reaktivgases beim Durchleiten durch den weiteren Hohlkörper 11' zu erzielen. Natürlich kann das Ausführungsbeispiel gemäß Figur 3 auch derart modifiziert werden, daß mehrere weitere Hohlkörper 11' mit verschiedenen Gasen oder verschiedenen, im Reaktivgas enthaltenen Gaskomponenten innerhalb des Hohlkörpers 11 angeordnet sind, die sich erst beim Eintreten des erzeugten freien kalten Plasmastrahles 21 in die Arbeitskammer 19 mit dem Gasplasma und untereinander vermischen.

## Patentansprüche

1. Vorrichtung zur Erzeugung eines freien kalten nicht-thermischen Plasmastrahls (21, 21') mit mindestens einer hochfrequenten Plasmaquelle (15) und mit mindestens einem für elektromagnetische Strahlung transparenten Hohlkörper (11), insbesondere einer Röhre, der mit mindestens einer Gaseintrittsöffnung (10) und mindestens einer Strahlaustrittsöffnung (13) versehen ist, wobei die hochfrequente Plasmaquelle (15) innerhalb des Hohlkörpers (11) ein kaltes nicht-thermisches Gasplasma (12) erzeugt, wobei die Vorrichtung eine vom Hohlkörper (11) separate Arbeitskammer (19) umfasst, wobei die Plasmaquelle (15) eine Mikrowellenplasmaquelle mit Schlitzantenneneinkopplung ist, wobei der Hohlkörper (11) als zumindest Teil eines Plasmaerzeugungsbgreichs (30) über ein als Metallring ausgebildetes Übergangselement (14, 14') mit der separaten Arbeitskammer (19) als zumindest Teil eines Arbeitsbereichs (31) verbunden ist, wobei der Metallring als Verbindung zwischen dem Plasmaerzeugungsbereich (30) und der Arbeitskammer (19) ohne weitere, zusätzlich erzeugte elektromagnetische Felder bewirkt, dass elektromagnetische Oberflächenwellen, welche sich an der Grenze zwischen dem Gasplasma (12) und dem Hohlkörper (11) ausbreiten, sich von dem Hohlkörper (11) in die Arbeitskammer (19) fortsetzen und das in dem Hohlkörper (11) erzeugte kalte nicht-thermische Gasplasma (12) als freier, kalter nicht-thermischer Plasmastrahl (21) über die Strahlaustrittsöffnung (13, 13') aus dem Hohlkörper (11) in die separate Arbeitskammer (19) eintritt und dort durch Oberflächenwellen gebündelt geführt wird.

2. Vorrichtung nach Anspruch 1, **dadurch gekennzeichnet, dass** in der Arbeitskammer (19) ein Druck von 0,1 Pa bis 1000 Pa herrscht.

3. Vorrichtung nach Anspruch 1, **dadurch gekennzeichnet, dass** in den Hohlkörper (11) über die Gaseintrittsöffnung (10) ein Gas mit einem Fluss von 10 sccm bis 10000 sccm einleitbar ist.

4. Vorrichtung nach Anspruch 3, **dadurch gekennzeichnet, dass** das Gas ein Edelgas, insbesondere Argon, oder Sauerstoff, Stickstoff oder Wasserstoff ist.

5. Vorrichtung nach Anspruch 1, **dadurch gekennzeichnet, dass** die hochfrequente Plasmaquelle (15) elektromagnetische Strahlung mit einer Leistung von 10 W bis 10kW, vorzugsweise von 500 W bis 2 kW über den Hohlkörper (11) in das kalte Glasplasma (12) einkoppelt.

6. Vorrichtung nach Anspruch 1, **dadurch gekennzeichnet, dass** die hochfrequente Plasmaquelle (15) eine Mikrowellenplasmaquelle ist, die mit Frequenzen von 300 MHz bis 30 GHz, vorzugsweise mit einer Frequenz von 2,45 GHz arbeitet.

7. Vorrichtung nach Anspruch 1, **dadurch gekennzeichnet, dass** der Hohlkörper (11) eine Röhre, insbesondere ein Glas-, Quarzglas- oder Keramikrohr ist.

8. Vorrichtung nach Anspruch 1, **dadurch gekennzeichnet, dass** dem freien kalten Plasmastrahl (21) in der Arbeitskammer (19) über mindestens eine Gaszuführung (16) ein Reaktivgas, insbesondere Acetylen, Methan, Silan oder Dampf von HMDS(O), TMS oder TEOS zuführbar ist.

9. Vorrichtung nach Anspruch 1, **dadurch gekennzeichnet, dass** sich die Gaseintrittsöffnung (10) und die Strahlaustrittsöffnung (13) gegenüberliegen.

10. Vorrichtung nach Anspruch 1, **dadurch gekennzeichnet dass** sich innerhalb des Hohlkörpers (11) mindestens ein weiterer Hohlkörper (11') mit jeweils mindestens einer Gaszuführung (16) befindet, durch den ein Reaktivgas oder eine Reaktivgas bildende Gaskomponente geleitet wird, derart, dass das Reaktivgas in der Arbeitskammer (19) koaxial in den freien kalten Plasmastrahl (21) eintritt.

11. Vorrichtung nach Anspruch 1, **dadurch gekennzeichnet, dass** die Strahlaustrittsöffnung (13') die Form eines Schlitzes und der freie Plasmastrahl flächig als Plasmastrahlebene (21') in die Arbeitskammer (19) austritt.

12. Verwendung der Vorrichtung nach mindestens einem der vorangehenden Ansprüche für Beschichtungen, zum Ätzen oder Reinigen von Oberflächen.

## Claims

1. Device for producing a free cold non-thermal plasma jet (21, 21') with at least one high-frequency plasma source (15) and with at least one hollow body (11) that is transparent to electromagnetic radiation, in particular a tube, which is provided with at least one gas inlet opening (10) and at least one jet outlet opening (13), wherein the high-frequency plasma source (15) produces a cold non-thermal gas plasma (12) within the hollow body (11), wherein the device comprises a working chamber (19), which is separate from the hollow body (11), wherein the plasma source (15) is a microwave plasma source with slot antenna injection, wherein the hollow body (11), as at least part of a plasma producing region (30), is connected by way of a transitional element (14, 14'), formed as a metal ring, to the separate working chamber (19), as at least part of a working region (31), wherein the metal ring, as a connection between the plasma producing region (30) and the working chamber (19), acts without further additionally produced electromagnetic fields to make electromagnetic surface waves that spread out at the interface between the gas plasma (12) and the hollow body (11) continue from the hollow body (11) into the working chamber (19), and the cold non-thermal gas plasma (12) that is produced in the hollow body (11) passes by way of the jet outlet opening (13, 13') out of the hollow body (11) into the separate working chamber (19) as a free, cold non-thermal plasma jet (23) and is guided there in a concentrated manner by surface waves.

2. Device according to Claim 1, **characterized in that** a pressure of 0.1 Pa to 1000 Pa prevails in the working chamber (19).

3. Device according to Claim 1, **characterized in that** a gas can be introduced into the hollow body (11) by way of the gas inlet opening (10) with a flow of 10 sccm to 10 000 sccm.

4. Device according to Claim 3, **characterized in that** the gas is a noble gas, in particular argon, or oxygen, nitrogen or hydrogen.

5. Device according to Claim 1, **characterized in that** the high-frequency plasma source (15) injects electromagnetic radiation with a power output of 10 W to 10 kW, preferably of 500 W to 2 kW, into the cold gas plasma (12) by way of the hollow body (11).

6. Device according to Claim 1, **characterized in that** the high-frequency plasma source (15) is a microwave plasma source, which operates at frequencies of 300 MHz to 30 GHz, preferably at a frequency of 2.45 GHz.

7. Device according to Claim 1, **characterized in that** the hollow body (11) is a tube, in particular a glass, quartz glass or ceramic tube.

8. Device according to Claim 1, **characterized in that** a reactive gas, in particular acetylene, methane, silane or vapour of HMDS(O), TMS or TEOS, can be fed to the free cold plasma jet (21) in the working chamber (19) by way of at least one gas feed (16).

9. Device according to Claim 1, **characterized in that** the gas inlet opening (10) and the jet outlet opening (13) lie opposite one another.

10. Device according to Claim 1, **characterized in that** inside the hollow body (11) there is at least one further hollow body (11') with in each case at least one gas feed (16), through which a reactive gas or a reactive-gas-forming gas component is passed in such a way that the reactive gas in the working chamber (19) coaxially enters the free gas plasma jet (21).

11. Device according to Claim 1, **characterized in that** the jet outlet opening (13') the form of a slot and the free plasma jet leaves into the working chamber (19) as a plasma jet in the form of a two-dimensional plane (21').

12. Use of the device according to at least one of the preceding claims for coatings, for etching or for cleaning surfaces.

## Revendications

1. Dispositif de production d'un jet de plasma froid non thermique libre (21, 21') comportant au moins une source de plasma à haute fréquence (15) et au moins un corps creux (11) transparent au rayonnement électromagnétique, notamment un tube, qui est muni d'au moins un orifice d'entrée de gaz (10) et d'au moins un orifice de sortie de jet de (13), dans lequel la source de plasma à haute fréquence (15) produit un plasma gazeux froid non thermique (12) à l'intérieur du corps creux (11), dans lequel le dispositif comprend une chambre de travail (19) séparée du corps creux (11), dans lequel la source de plasma (15) est une source de plasma micro-ondes à injection par antenne à fente, dans lequel le corps creux (11), qui constitue au moins une partie d'une région de production de plasma (30), est relié par l'intermédiaire d'un élément de transition (14, 14') réalisé sous la forme d'une bague métallique à la chambre de travail séparée (19), qui constitue au moins une partie d'une région de travail (31), dans lequel la bague métallique, en tant que liaison entre la région de production de plasma (30) et la chambre de travail (19) fait en sorte, sans autre champ électromagnétique produit de manière supplémentaire, que des ondes de surface électromagnétiques, qui se propagent à la frontière entre le plasma gazeux (12) et le corps creux (11), se prolongent du corps creux (11) vers la chambre de travail (19) et que le plasma gazeux froid non thermique (12) produit dans le corps creux (11) soit guidé sous la forme d'un jet de plasma libre froid non thermique (21) pénètre par l'intermédiaire de l'ouverture de sortie de jet (13, 13') depuis le corps creux (11) dans la chambre de travail séparé (19) et y soit guidé de manière regroupée par des ondes de surface.

2. Dispositif selon la revendication 1, **caractérisé en ce qu'**il règne dans la chambre de travail (19) une pression de 0,1 Pa à 1000 Pa.

3. Dispositif selon la revendication 1, **caractérisé en ce qu'**un gaz peut être introduit dans le corps creux (11) par l'intermédiaire de l'orifice d'entrée de gaz (10) avec un débit de 10 sccm à 10000 sccm.

4. Dispositif selon la revendication 3, **caractérisé en ce que** le gaz est un gaz rare, notamment l'argon, ou l'oxygène, l'azote ou l'hydrogène.

5. Dispositif selon la revendication 1, **caractérisé en ce que** la source de plasma à haute fréquence (15) injecte, par l'intermédiaire du corps creux (11), dans le plasma gazeux froid (12) un rayonnement électromagnétique ayant une puissance de 10 W à 10 kW, de préférence de 500 W à 2 kW.

6. Dispositif selon la revendication 1, **caractérisé en ce que** la source de plasma à haute fréquence (15) est une source de plasma micro-ondes qui fonctionne à des fréquences de 300 MHz à 30 GHz, de préférence, à une fréquence de 2,45 GHz.

7. Dispositif selon la revendication 1, **caractérisé en ce que** le corps creux (11) est un tube, notamment un tube de verre, un tube de verre de quartz ou un tube de céramique.

8. Dispositif selon la revendication 1, **caractérisé en ce qu'**un gaz réactif, notamment l'acétylène, le méthane, le silane ou de la vapeur de HMDS(O), de TMS ou de TEOS, peut-être introduit dans le jet de plasma froid libre (21) dans la chambre de travail (19) par l'intermédiaire d'au moins une alimentation en gaz (16).

9. Dispositif selon la revendication 1, **caractérisé en ce que** l'orifice d'entrée de gaz (10) et l'orifice de sortie de jet (13) sont superposés.

10. Dispositif selon la revendication 1, **caractérisé en ce qu'**à l'intérieur du corps creux (11) se trouve au moins un autre corps creux (11') respectivement muni d'au moins une alimentation en gaz (16), au moyen duquel un gaz réactif ou un constituant gazeux formant un gaz réactif est acheminé de manière à ce que le gaz réactif dans la chambre de travail (19) pénètre coaxialement dans le jet de plasma libre froid (21).

11. Dispositif selon la revendication 1, **caractérisé en ce que** l'orifice de sortie de jet (13') la forme d'une fente et le jet de plasma libre sort dans la chambre de travail (19) de manière plane sous la forme d'un plan de jet de plasma (21').

12. Utilisation du dispositif selon l'une quelconque des revendications précédentes pour revêtir, graver ou nettoyer des surfaces.
